(19) Europäisches Patentamt
European Patent Office
Office européen des brevets

(11) Publication number : **0 498 571 A1**

(12) **EUROPEAN PATENT APPLICATION**

(21) Application number : **92300820.5**

(22) Date of filing : **30.01.92**

(51) Int. Cl.⁵ : **G01R 33/34**

(30) Priority : **05.02.91 US 651064**

(43) Date of publication of application :
**12.08.92 Bulletin 92/33**

(84) Designated Contracting States :
**DE FR GB NL**

(71) Applicant : **GENERAL ELECTRIC COMPANY**
**1 River Road**
**Schenectady, NY 12345 (US)**

(72) Inventor : **Kang, Yoon Won**
**124 Thoreau Drive**
**Plainsboro, New Jersey 08536 (US)**

(74) Representative : **Pratt, Richard Wilson**
**London Patent Operation G.E. Technical**
**Services Co. Inc. Essex House 12/13 Essex**
**Street**
**London WC2R 3AA (GB)**

(54) **NMR radio frequency coil with dielectric for improved operating efficiency.**

(57) An RF coil assembly for an NMR instrument includes a cylindrical coil (10) surrounded by a cylindrical shield (11). The annular space (13) between the coil and the shield is filled with a dielectric material having a high relative permittivity which increases the efficiency of the coil assembly by reducing the applied RF power necessary to produce the required magnetic flux density.

FIG. 2

EP 0 498 571 A1

## Background of the Invention

This invention relates to nuclear magnetic resonance (NMR) apparatus. More specifically, this invention relates to radio frequency (RF) coils useful with such apparatus for transmitting and/or receiving RF signals.

In the past, the NMR phenomenon has been utilized by structural chemists to study, in vitro, the molecular structure of organic molecules. Typically, NMR spectrometers utilized for this purpose were designed to accommodate relatively small samples of the substance to be studied. More recently, however, NMR has been developed into an imaging modality utilized to obtain images of anatomical features of live human subjects, for example. Such images depicting parameters associated with nuclear spins (typically hydrogen protons associated with water in tissue) may be of medical diagnostic value in determining the state of health of tissue in the region examined. NMR techniques have also been extended to in vivo spectroscopy of such elements as phosphorus and carbon, for example, providing researchers with the tools, for the first time, to study chemical processes in a living organism. The use of NMR to produce images and spectroscopic studies of the human body has necessitated the use of specifically designed system components, such as the magnet, gradient and RF coils.

The nuclear magnetic resonance phenomenon occurs in atomic nuclei having an odd number of protons or neutrons. Due to the spin of the protons and neutrons, each such nucleus exhibits a magnetic moment, such that, when a sample composed of such nuclei is placed in a static, homogeneous magnetic field, $B_o$, a greater number of nuclear magnetic moments align with the field to produce a net macroscopic magnetization M in the direction of the field. Under the influence of the magnetic field $B_o$, the aligned magnetic moments precess about the axis of the field at a frequency which is dependent on the strength of the applied magnetic field and on the characteristics of the nuclei. The angular precession frequency, $\omega$, also referred to as the Larmor frequency, is given by the Larmor equation $\omega = \gamma B$ in which $\gamma$ is the gyromagnetic ratio (which is constant for each NMR isotope) and wherein B is the magnetic field ($B_o$ plus other fields) acting upon the nuclear spins. It will be thus apparent that the resonant frequency is dependent on the strength of the magnetic field in which the sample is positioned.

The orientation of magnetization M, normally directed along the magnetic field $B_o$, may be perturbed by the application of magnetic fields oscillation at or near the Larmor frequency. Typically, such magnetic fields designated $B_1$ are applied orthogonal to the direction of the $B_o$ field by means of RF pulses through a coil connected to a radio-frequency-transmitting apparatus. Under the influence of RF excitation, magnetization M rotates about the direction of the $B_1$ field. In NMR studies, it is typically desired to apply RF pulses of sufficient magnitude and duration to rotate magnetization M into a plane perpendicular to the direction of the $B_o$ field. This plane is commonly referred to as the transverse plane. Upon cessation of the RF excitation, the nuclear moments rotated into the transverse plane precess around the direction of the static field. The vector sum of the spins forms a precessing bulk magnetization which can be sensed by an RF coil. The signals sensed by the RF coil, termed NMR signals, are characteristic of the magnetic field and of the particular chemical environment in which the nuclei are situated. In NMR imaging applications, the NMR signals are observed in the presence of magnetic-field gradients which are utilized to encode spatial information into the signals. This information is later used to reconstruct images of the object studied in a manner well-known to those skilled in the art.

In performing whole-body NMR studies, it has been found advantageous to increase the strength of the homogeneous magnetic field $B_o$. This is desirable in the case of proton imaging to improve the signal-to-noise ratio of the NMR signals. In the case of spectroscopy, however, this is a necessity, since some of the chemical species studied (e.g., phosphorus and carbon) are relatively scarce in the body, so that a high magnetic field is necessary in order to detect usable signals. As is evident from the Larmor equation, the increase in magnetic field B is accompanied by a corresponding increase in frequency and, hence, in the required resonant frequency of the transmitter and receiver coils. This complicates the design of RF coils which are large enough to accommodate the human body. One source of difficulty is that the RF field generated by the coil must be homogeneous over the body region to be studied to produce more uniform measurements and images. The production of uniform RF magnetic fields over large volumes becomes increasingly difficult at high frequencies owing to unwanted effects of stray capacitances between different parts of RF coils and between RF coils and surrounding objects or the NMR sample, itself, which limit the highest frequency at which the coil can be made to resonate.

RF coils which produce substantially homogeneous fields at high frequencies throughout large volumes have been designed. Such coils are disclosed, for example, in U.S. Patent No. 7,680,548 for use in whole body imaging of hydrogen nuclei at 1.5 Tesla, and U.S. Patent No. 4,799,016 for use as a local coil in imaging both hydrogen and phosphorous nuclei at 1.5 Tesla.

In addition to field homogeneity, another design objective of RF coils for NMR images and spectrometers is that they produce the desired magnetic flux density $B_1$ efficiently. That is, for a given magnetic flux density $B_1$ produced in the sample, or patient, a minimal RF electrical power is applied to the coil. It is known that much of the RF loss which reduces the efficiency of the system is caused by dielectric loss within the sample, or patient, in which the field is produced.

## Summary of the Invention

The present invention relates to an RF coil assembly for an NMR instrument in which the losses due to the insertion of a sample, or patient, into the RF coil's field are reduced and the overall efficiency of the RF coil assembly is increased. More specifically, the RF coil assembly includes: an active element which is shaped to define a region of interest into which an NMR sample is placed; an RF power source which is connected to the active element and which generates a current therein that produces a desired magnetic field ($B_1$) in the NMR sample; a grounded shield disposed adjacent the active element to confine the magnetic field produced thereby to the region of interest; and a high permittivity dielectric material disposed between the active element and the adjacent grounded shield to reduce the electric field intensity (E) required to produce the desired magnetic field $B_1$ in the sample.

A general object of the invention is to improve the operating efficiency of the RF coil assembly. By increasing the permittivity of the dielectric material between the active element and its shield, the characteristic impedance ($Z_o$) of the coil assembly is reduced with the result that a lower voltage is necessary to produce the required coil current. This reduction in applied voltage results in a corresponding reduction in the electric field intensity (E) and the losses which occur due to the application of that field to the sample.

A more specific object of the invention is to improve the efficiency of an RF coil assembly such as those described in the above-cited U.S. Patent Nos. 4,680,548 and 4,799,016. The active element in such coil assemblies is comprised of a set of linear conductors which are disposed around a cylindrical shaped region of interest and a cylindrical shield which is disposed around, and spaced radially outward from the active element. The present invention is carried out by filling the annular space between the active element and its surrounding shield with a high permittivity dielectric material.

The foregoing and other objects and advantages of the invention will appear from the following description. In the description, reference is made to the accompanying drawings which form a part hereof, and in which there is shown by way of illustration a preferred embodiment of the invention. Such embodiment does not necessarily represent the full scope of the invention, however, and reference is made therefore to the claims herein for interpreting the scope of the invention.

## Brief Description of the Drawings

Figs. 1a and 1b are schematic drawings used to explain how the present invention works;
Fig. 2 is a schematic drawing of a preferred embodiment of an RF coil assembly which employs the present invention;
Fig. 3 is a pictorial view of a coil assembly which employs the present invention; and
Figs. 4a-4c are schematic representations of alternative embodiments of the coil assembly of Fig. 2.

## General Description of the Invention

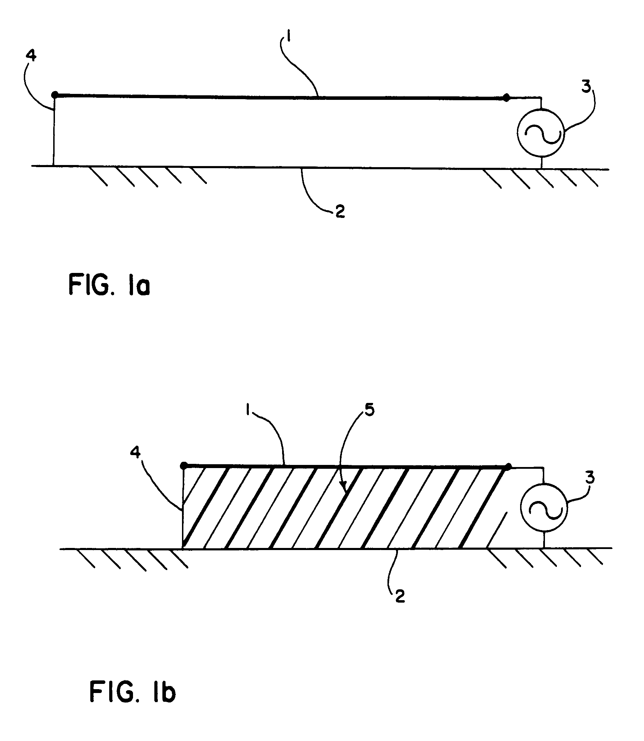

Referring particularly to Fig. 1a, a single z-directed coil element 1 is spaced from a ground plane 2. One end of the coil element is driven by an RF signal source 3 to apply a voltage $V_{in}$ and produce a current $I_{in}$. The other end of the coil element 1 is connected to the ground plane at 4. The space between the coil element 1 and the ground plane 2 is filled with air which has a relative permittivity ($\varepsilon_r$) of one. In Fig. 1b the same structure is illustrated, but the space between the coil element 1 and the ground plane 2 is now filled with a low loss, high permittivity dielectric material 5 which has a relative permittivity greater than one ($\varepsilon_r > 1$). The purpose of this increase in relative permittivity is to increase the RF transmission efficiency.

This increase in efficiency results from a reduction in the power dissipation due to dielectric loss. The complex permittivity of the medium in which the electric field is produced is $\varepsilon = \varepsilon' - j\varepsilon''$. The time-average electric energy stored and dissipated in a specified volume $\tau$ in this medium is given as

$$U_e = \int_\tau \varepsilon \, |E|^2 \, d\tau = \int_\tau \varepsilon' \, |E|^2 \, d\tau - j \int_\tau \varepsilon'' \, |E|^2 \, d\tau, \qquad (1)$$

3

where E is the electric field strength on the coil element due to voltage V.

Then the time-average power dissipation due to dielectric loss can be found as

$$P_{loss} = \omega \cdot \int_{\tau} \varepsilon'' \; |E|^2 \; d\tau \qquad (2)$$

where $\omega$ is the angular frequency of the operating frequency. It is assumed that the addition of the lossless high permittivity dielectric material 5 can increase the real part of $\varepsilon$, while keeping the imaginary part ($\varepsilon''$) almost the same.

Depending on the volume ratio of dielectric to air in the coil region, the effective dielectric constant can be $1 < \varepsilon_r^{eff} < \varepsilon_r$

The voltage wave along $l$ on the coil element 1, without dielectric loading, can be expressed as:

$$V_0(l) = V_m^+ e^{-\gamma_0 l} + V_m^- e^{+\gamma_0 l} \qquad (3)$$

or

$$|V_0(l)| = V_m^+ e^{-\gamma_0 l} |1 + \Gamma_0(l)| \qquad (4)$$

where the complex reflection coefficient, $\Gamma_0$, is:

$$\Gamma_0(l) = \frac{V_m^-}{V_m^+} e^{2\gamma_0 l} \qquad (5)$$

and where $V_m^+$ and $V_m^-$ denote the magnitudes of the incident and the reflected voltages on the coil element 1, respectively. The current wave along $l$ on the coil element 1 is then:

$$|I_0(l)| = \frac{V_m^+}{Z_0} e^{-\gamma_0 l} |1 - \Gamma_0(l)| \qquad (6)$$

where $Z_0$ is the characteristic impedance of the coil element 1. The magnetic flux in the coil region is proportional to the coil current $|I_0(l)|$.

Assuming that a current $|I^d(l)|$ can produce the desired magnetic flux density in the coil region, then if the reflection coefficient remains unchanged with the dielectric loading, that is $\Gamma^d(l) = \Gamma_0(l)$, then $V_m^+$ is reduced by $\sqrt{\varepsilon_r^{eff}}$ for a current distribution on the coil $|I^d(l)| \approx |I_0(l)|$. This is because the characteristic impedance with dielectric loading $Z_d = Z_0/\sqrt{\varepsilon_r^{eff}}$.

Since the voltage on the conductor element 1 is:

$$V(l) = \int_{ground}^{coil} \bar{E}(l) \cdot d\bar{R}, \qquad (7)$$

where $\bar{R}$ is the radial vector directed from the coil element 1 to the ground plane 2. The voltage $V^d(l)$ due to dielectric loading is shown as:

$$V^d(l) = \frac{V_m^+}{\sqrt{\varepsilon_r^{eff}}} e^{-\gamma^d l} |1 + \Gamma^d(l)| \qquad (8)$$

Then, the electric field is reduced by $\sqrt{\varepsilon_r^{eff}}$ with dielectric loading as $E^d = E_0/\sqrt{\varepsilon_r^{eff}}$ where $E_0$ is the electric field intensity on the active element with no dielectric loading. This shows that the power dissipation, $P_{loss}$ in equation (2) can be reduced by up to $\varepsilon_r^{eff}$ for a dielectric loaded conductor element 1 compared to the conductor element 1 without dielectric loading.

Note that this power reduction is achieved without reducing the length L of the coil element 1, if $L \ll \lambda$ or the coil element is reactively loaded to maintain a near uniform current of $I^d(l)$. The improvement of the transmission efficiency can be greater for smaller $\varepsilon''/\varepsilon'$.

The above discussion for a single coil element 1 can be applied to a circular array of many coil elements. An angular coil element can be treated in the same way, and thus, this approach can also be applied to many NMR coils.

Description of the Preferred Embodiment

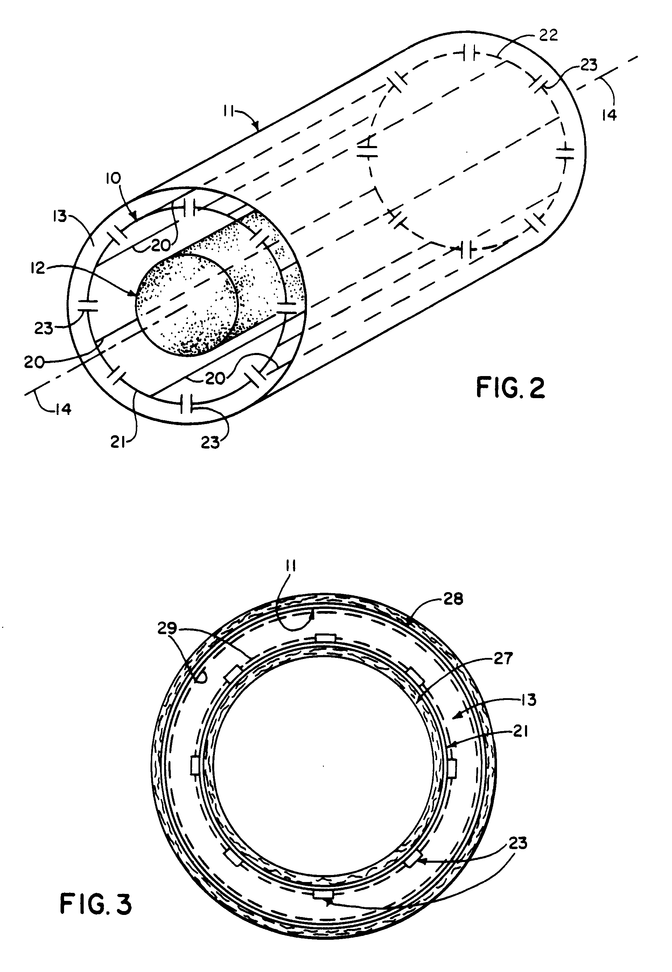

Fig. 2 illustrates a coil assembly which employs a so-called "high-pass" coil 10 which is surrounded by a solid metal shield 11. The coil 10 is comprised of a set of linear conductive elements 20 which extend in the axial direction and which are spaced equidistantly from each other around the inner surface of the shield 11. Circular conductors 21 and 22 are positioned at each end of the coil 10 and they connect the respective ends of the linear conductors 20 to form a structure which is referred to in the art as a "birdcage" coil. Capacitors 23 are inserted in each segment of the circular conductors 21 and 22, and these are used to tune the coil. When driven by an RF signal source (not shown), the coil 10 produces an RF magnetic field which fills the cylindrical space occupied by the subject and which is directed transversely to the central axis 14.

A body, or subject 12 under study is disposed in the cylindrical cavity formed by the coil 10 and there is an annular space 13 between the coil 10 and the shield 11. While the grounded shield 11 is not connected to the conductive elements of the coil 10, the analysis of the fields produced by the coil element 1 described above applies to this structure in the same manner.

Referring particularly to Fig. 3, in one preferred embodiment of the invention the RF coil 10 is formed on the outer surface of a cylindrical fiber-glass form 27 and the shield 11 is formed on the inner surface of an outer cylindrical shaped fiber-glass form 28. The annular space 13 is filled with a thin-walled polyethylene sack 29 that contains a mixture of distilled water and isopropanol. Isopropanol has a relative permittivity of approximately 18 and the relative permittivity of water is 78. By changing the ratio of water and isopropanol and the thickness of the polyethylene sack 29, the effective relative permittivity can be set to a range of values. For example, if the thickness of the polyethylene sack 29 occupies 5% of the annular space 13 and it is filled with distilled water, the effective relative permittivity is approximately 30.

In the alternative, solid dielectric materials can be shaped to fit in the annular space 13. One such material which is sold under the trademark "STYCAST" by Emerson and Cumming, Inc. has a relative permittivity of 30.

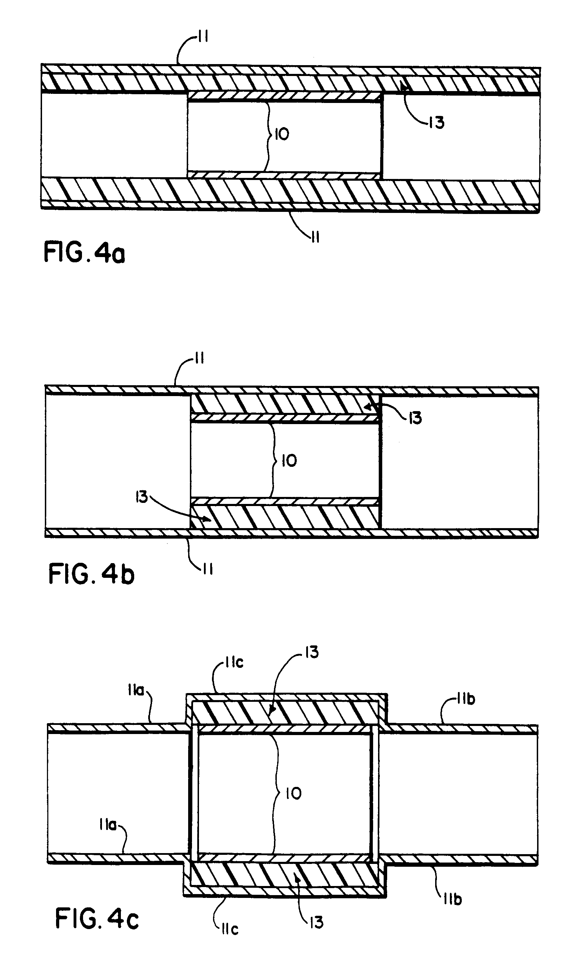

The present invention may be employed with equal effectiveness to a number of alternative structures as illustrated schematically in Figs. 4a-4c. In Fig. 4a the coil 10 has an axial length which is substantially shorter than the surrounding shield 11 and dielectric material 13. In Fig. 3b the same result is achieved by shortening the dielectric material 13 to the same length as the coil 10, and in Fig. 3c, the extended end segments 11a and 11b of the shield 11 are made co-planer with the coil 10, while its mid-section 11c remains in its radially outward position with the dielectric material 13 therebetween.

## Claims

1. An RF coil assembly for an NMR instrument, the combination comprising:
   a cylindrical coil disposed around a central axis and defining a cylindrical cavity into which a subject to be examined is subjected to a transversely directed RF field produced by the coil;
   a cylindrical shield disposed concentrically around the cylindrical coil and spaced outward therefrom to define an annular space between an outer surface of the cylindrical coil and an inner surface of the shield; and
   a dielectric material disposed in the annular space to increase the permittivity of the annular space to a value which is substantially greater than the permittivity of air and to thereby decrease the voltage which must be applied to the coil in order to maintain a given magnetic flux density within the cylindrical cavity and to thereby increase the efficiency of the coil assembly.

2. The RF coil assembly as recited in claim 1 in which the cylindrical coil is comprised of a set of linear conductors that extend in the direction of the central axis and which are spaced radially outward therefrom and distributed around the central axis.

3. The RF coil assembly as recited in claim 2 in which the ends of said linear conductors are joined together by a pair of circular conductors that are spaced apart and concentric about the central axis.

FIG. 1a

FIG. 1b

FIG. 2

FIG. 3

FIG.4a

FIG.4b

FIG.4c

EP 0 498 571 A1

**European Patent Office**

# EUROPEAN SEARCH REPORT

Application Number

EP 92 30 0820

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| P,X | WO-A-9 110 915 (GENERAL ELECTRIC COMPANY)<br>* page 14, line 1 - line 24 *<br>* page 16, line 1 - page 19, line 4; figures 1,2 * | 1-3 | G01R33/34 |
| A | US-A-4 751 464 (J.F.BRIDGES)<br>* column 3, line 3 - line 57 *<br>* column 9, line 3 - line 27 * | 1-3 | |
| A | DE-A-3 839 046 (BRUKER MEDIZINTECHNIK GMBH)<br>* column 1, line 3 - line 45 *<br>* column 5, line 15 - column 7, line 16; figure * | 1-3 | |
| A | US-A-4 924 184 (K. YODA)<br>* column 1, line 23 - column 2, line 45 *<br>* column 5, line 40 - column 6, line 17; figures 2,3,5 * | 1-3 | |
| A | PHYSICS IN MEDECINE AND BIOLOGY.<br>vol. 27, no. 3, 1 March 1982, LONDON GB<br>pages 443 - 447;<br>T.W. REDPATH ET AL.: 'DESIGN OF A RADIOFREQUENCY COIL SUITABLE FOR NMR IMAGING OF HEADS'<br>* the whole document * | 1,2 | **TECHNICAL FIELDS SEARCHED (Int. Cl.5 )**<br><br>G01R |
| A | REVIEW OF SCIENTIFIC INSTRUMENTS.<br>vol. 59, no. 6, 1 June 1988, NEW YORK US<br>pages 926 - 929;<br>J.C. WATKINS ET AL.: 'HIGH-PASS BIRD-CAGE COIL FOR NUCLEAR-MAGNETIC RESONANCE'<br>* the whole document * | 1-3 | |

The present search report has been drawn up for all claims

| Place of search | Date of completion of the search | Examiner |
|---|---|---|
| THE HAGUE | 12 MAY 1992 | HORAK G.I. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

9